# EUROPÄISCHE PATENTSCHRIFT

(11) **EP 2 926 154 B1**
(45) Veröffentlichungstag und Bekanntmachung des Hinweises auf die Patenterteilung: **12.06.2019**
(21) Anmeldenummer: 13805804.5
(22) Anmeldetag: 29.11.2013
(51) Int. Cl.: G01R 31/36

(54) **VERFAHREN UND VORRICHTUNG ZUM ÜBERWACHEN DER FUNKTIONSFÄHIGKEIT EINES AKKUMULATORS**
METHOD AND DEVICE FOR MONITORING THE PROPER FUNCTIONING OF A RECHARGEABLE BATTERY
PROCÉDÉ ET DISPOSITIF DE SURVEILLANCE DE LA CAPACITÉ DE FONCTIONNEMENT D'UN ACCUMULATEUR

(30) Priorität: 29.11.2012 DE 102012111591
(43) Veröffentlichungstag der Anmeldung: 07.10.2015
(73) Patentinhaber: Phoenix Contact GmbH & Co. KG, 32825 Blomberg (DE)
(72) Erfinder: NEUENDORF, Andreas, 32839 Steinheim (DE); HEINEMANN, Michael, 32791 Lage (DE); MANTLER, Eugen, 32839 Steinheim (DE)
(74) Vertreter: Blumbach · Zinngrebe Patent- und Rechtsanwälte
(86) Internationale Anmeldenummer: PCT/EP2013/075123
(87) Internationale Veröffentlichungsnummer: WO 2014/083168

(56) Entgegenhaltungen:
- EP-A1- 1 548 453
- EP-A1- 1 933 158
- EP-A2- 1 933 159
- WO-A1-2011/155184
- DE-A1- 10 203 810
- DE-A1-102005 052 448
- JP-A- 2001 110 459
- US-A1- 2006 066 285
- US-A1- 2008 054 848
- US-A1- 2008 103 709
- US-A1- 2010 001 693
- US-A1- 2011 172 939
- US-B2- 7 615 967
- US-B2- 7 616 003
- US-B2- 7 928 735
- TAKAHASHI K ET AL: "Development of SOH monitoring system for industrial VRLA battery string", INTELEC 2003. 25TH. INTERNATIONAL TELECOMMUNICATIONS ENERGY CONFERENCE. YOKOHAMA, JAPAN, OCT. 19 - 23, 2003; [INTELEC. INTERNATIONAL TELECOMMUNICATIONS ENERGY CONFERENCE], TOKYO, IEICE, JP, 23. Oktober 2003 (2003-10-23), Seiten 664-670, XP031895552, ISBN: 978-4-88552-196-6
- FRANCESCO MARRA ET AL: "Average behavior of battery-electric vehicles for distributed energy studies", INNOVATIVE SMART GRID TECHNOLOGIES CONFERENCE EUROPE (ISGT EUROPE), 2010 IEEE PES, IEEE, PISCATAWAY, NJ, USA, 11. Oktober 2010 (2010-10-11), Seiten 1-7, XP031803723, ISBN: 978-1-4244-8508-6
- MINORU KITAGAWA ET AL: "DEVELOPMENT OF BATTERY STATE OF CHARGE INDICATOR FOR ELECTRIC VEHICLES", INTERNATIONAL ELECTRIC VEHICLE SYMPOSIUM. ANAHEIM, DEC. 5 - 7, 1994; [INTERNATIONAL ELECTRIC VEHICLE SYMPOSIUM], SAN FRANCISCO, EVAA, US, Bd. SYMP. 12, 5. Dezember 1994 (1994-12-05), Seiten 293-302, XP000488482,
- MYUNGSOO K ET AL: "Monitoring the battery status for photovoltaic systems", JOURNAL OF POWER SOURCES, ELSEVIER SA, CH, Bd. 64, Nr. 1-2, 1. Januar 1996 (1996-01-01), Seiten 193-196, XP004075211, ISSN: 0378-7753, DOI: 10.1016/S0378-7753(96)02521-9

## Beschreibung

Die vorliegende Erfindung betrifft im allgemeinen Akkumulatoren sowie Akkumulator-betriebene unterbrechungsfreie Stromversorgungssysteme. Insbesondere betrifft die vorliegende Erfindung ein Verfahren und eine Vorrichtung zum Überwachen der Funktionsfähigkeit eines Akkumulators, sowie eine unterbrechungsfreie Stromversorgung, die eine solche Vorrichtung aufweist.

In vielen elektrischen Anlagen werden Systeme zur unterbrechungsfreien Stromversorgung (USV) zur Sicherstellung des Betriebs der elektrischen Anlagen unabhängig von Störungen im Energieversorgungsnetz verwendet. Eine USV dient dazu, bei einer Störung der normalen Energieversorgung eine hilfsweise Energieversorgung bereitzustellen. Daher wird im Folgenden für USV auch der Begriff der elektrischen Hilfsversorgung verwendet.

Typischerweise werden zur hilfsweisen Stromversorgung Akkumulatoren eingesetzt, die an eine elektrische Hilfsversorgungsvorrichtung angeschlossen sind und eine an die elektrische Hilfsversorgungsvorrichtung angeschlossene Last hilfsweise mit elektrischer Energie versorgen. Ein Akkumulator ist ein Speicher für elektrische Energie, typischerweise auf Basis eines elektrochemischen Systems, welcher eine oder mehrere Sekundärzellen umfasst, die zur Erhöhung der Gesamtspannung in Reihe oder zur Erhöhung der Kapazität parallel geschaltet sein können. Im Folgenden wird der Begriff Batterie für aufladbare Batterien und somit synonym für Akkumulator verwendet.

Während des Normalbetriebs des Energieverteilungsnetzes wird von der elektrischen Hilfsversorgungsvorrichtung elektrische Energie sowohl an die angeschlossene Last als auch an die Batterie geliefert. Wenn eine Störung im Energieversorgungsnetz auftritt, beginnt sich die Batterie zur Last hin zu entladen, deren elektrische Energieversorgung somit nicht gestört wird. Wenn das Energieverteilungsnetz zu seinem normalen Betrieb zurückkehrt, erfolgt wiederum eine Lieferung von elektrischer Energie sowohl an die Last als auch an die Batterie.

Bei Anlagen mit unterbrechungsfreien Stromversorgungen (USV) mit hohen Erwartungen an die Verfügbarkeit ist die Batterie der USV das Element, das entscheidend die mögliche Dauer des Batteriebetriebs, also die mögliche Pufferzeit, sowie die Lebensdauer der Anlage und somit die Verfügbarkeit bestimmt.

Daher kommt dem Batteriemanagement einer USV eine große Bedeutung zu. Eine Batterie, die typgerecht behandelt wird, erhöht die Verfügbarkeit der Anlage nennenswert. Auch die Information des SOH (State Of Health) einer Batterie, die während der Gebrauchszeit ständig vorliegt, erhöht die Verfügbarkeit der Anlage nennenswert, denn mit dieser Information kann ein Anwender frühzeitig auf einen notwendigen Ersatz der Batterie hingewiesen werden.

Bekannte Verfahren zum Ermitteln des typischerweise in Prozent angegebenen SOH erfassen Betriebsereignisse, die gewichtet gezählt werden und die unter Benutzung von Datenblattangaben zu Abnutzungswerten und weiter zu Werten des SOH der Batterie führen. Ebenso führt die Betriebstemperatur der Batterie rechnerisch zu Abnutzungswerten und weiter zu Werten des SOH der Batterie. Ein SOH-Wert von 100 % entspricht üblicherweise dem idealen Zustand einer Batterie zum Zeitpunkt der Auslieferung, d.h. vor Aufnahme der Benutzung. Ein SOH-Wert von 0 % entspricht typischerweise dem Ende der Lebensdauer einer Batterie, d.h. dem Zeitpunkt, zu dem die Batterie ausgetauscht werden sollte.

Der als SOH bezeichnete Gesundheitszustand einer Batterie stellt keinen Messwert einer physikalischen Größe, sondern vielmehr ein auf unterschiedliche Weise festlegbares Maß für die Funktionsfähigkeit einer Batterie dar, wobei dieses Maß indirekt auch ein Maß für die Restlebensdauer und die Restkapazität der Batterie sein kann, wobei einem SOH-Wert von 0 % je nach Einsatzzweck unterschiedliche Restkapazitäten entsprechen können. Ein Akkumulator kann als unbrauchbar angesehen werden, wenn dessen Restkapazität unter einen durch den Einsatzzweck vorgegebenen Anteil, beispielsweise 70 %, der Anfangskapazität gesunken ist.

Bei bekannten Verfahren zum Ermitteln des SOH einer Batterie werden jeweils Betriebsereignisse erfasst, die anhand von Berechnungen und Vergleichen mit Datenblattangaben zu Werten des SOH führen, die für die jeweilige Batterie typisch sind. Mit anderen Worten wird eine Schätzung des SOH vorgenommen, die auf einem typischen und dementsprechend erwarteten Abnutzungsverhalten einer Batterie basiert.

Zusätzlich zur Berechnung des SOH wird in der Regel durch eine messtechnische Erfassung des Innenwiderstands geprüft, ob die Batterie bereits defekt ist.

Die Qualität einer Batterie anhand einer Messung der vorhandenen Kapazität zu beurteilen ist bei USV-Geräten in der Regel nicht praktikabel, weil hierzu die Batterie einmal komplett entladen werden müsste und dann für die Zeit der Wiederaufladung keine ausreichende Pufferbereitschaft für den Energieversorgungsausfall zur Verfügung stehen würde.

Aus US 7 928 735 B1 ist ferner ein Überwachungsgerät für Batterien bekannt, bei welchem ein Wert für den SOH einer Batterie in Abhängigkeit des Innenwiderstandes ermittelt wird, wobei dabei von der Erkenntnis ausgegangen wird, dass der Unterschied zwischen dem Innenwiderstand einer vollaufgeladenen Batterie während des Ladens und nach dem Laden für eine Batterie in schlechtem Zustand größer ist als für eine Batterie in gutem Zustand.

Der US 7 615 967 B2 ist ein Verfahren und eine Vorrichtung zum Schätzen eines SOH-Wertes einer Batterie zu entnehmen, wobei der SOH-Wert mittels einer gespeicherten Schätz-Tabelle geschätzt wird, die SOH-Werte umfasst, denen jeweils für unterschiedliche Temperaturen und Ladungszustände verschiedene Innenwiderstandswerte zugeordnet sind.

US 7 593 823 B2 beschreibt ein Verfahren zur Bestimmung des Zustands einer Batterie mittels einer vorgegebenen Berechnungsformel in Abhängigkeit von gemessenen Werten der Temperatur, des Ladezustands und des Innenwiderstands, wobei Parameter der Berechnungsformel iterativ ermittelt werden.

In DE 10 2005 052 448 A1 wird ein Verfahren zum Ermitteln der Funktionsfähigkeit einer Batterie beschrieben, wobei als Maß für die Gebrauchstüchtigkeit (SOH) einer Batterie die Anzahl der Restbetätigungszyklen eines sicherheitsrelevanten Verbrauchers bestimmt wird, wobei die Leerlaufspannung sowie der Innenwiderstand in Form von Kennlinien in Abhängigkeit der Temperatur und des Ladezustandes abgelegt werden und durch Messung der Leerlaufspannung, des Innenwiderstandes und der Temperatur und durch anschließendes Rückwärtsablesen der Kennlinien ein Schätzwert des Ladezustand ermittelt wird, wobei ein Schätzwert der Anzahl der Restbetätigungszyklen aus der benötigten Arbeit, zeitlich aufintegriert über den Leistungsbedarf einer Betätigung und der daraus abgeleiteten Endlademenge berechnet wird.

US 2010/001693 A1 beschreibt eine Schaltung zum Ermitteln des Verschleißes einer sekundären Batterie, welche Einheiten zum Ermitteln des SOC und des Innenwiderstands umfasst.

US 2011/172939 A1 beschreibt ein System und ein Verfahren zum Überwachen einer Batterie, bei welcher der Innenwiderstand ermittelt wird.

WO 2011/155184 A1 beschreibt eine arithmetische Verarbeitungseinheit zur Berechnung des inneren Widerstands einer Batterie, der in Abhängigkeit des jeweiligen Ladezustands korrigiert werden kann.

EP 1 933 158 A1 beschreibt ein Verfahren und eine Vorrichtung zur Alterungsbestimmung einer Batterie, wobei iterativ zunächst ein Wert für den SOC ermittelt wird und dann ein Wert für den SOH.

US 2008/103709 beschreibt ein Batterie-Management-System mit einer Mikrocontroller-Einheit, die einen Wert für den inneren Widerstand der Batterie bestimmt, welcher einem geschätzten Ladezustand entspricht.

Der Erfindung liegt die Aufgabe zugrunde, einen Weg aufzuzeigen, wie auf eine gegenüber dem Stand der Technik vereinfachte und/oder verbesserte Weise die Funktionsfähigkeit eines Akkumulators ermittelt werden kann.

Diese Aufgabe wird durch ein Verfahren gemäß Anspruch 1, eine Vorrichtung gemäß Anspruch 11, sowie eine unterbrechungsfreie Stromversorgung gemäß Anspruch 16 gelöst. Vorteilhafte Ausführungsformen und Weiterbildungen sind in den jeweiligen Unteransprüchen angegeben.

Die Auswertung von Messwerten des Innenwiderstandes eines Akkumulators ist insofern problematisch, als der Innenwiderstand kein statischer Wert ist, sondern eng mit der Chemie des Akkumulators verbunden ist und sich permanent mit der Temperatur, der Ladung und der Alterung des Akkumulators ändert.

Mit der Messung des Innenwiderstandes kann bei einer unterbrechungsfreien Stromversorgung festgestellt werden, ob ein installierter Akkumulator bereits unbrauchbar ist. Zu diesem Zweck wird bei bekannten Verfahren der Innenwiderstand typischerweise nur zu einem bestimmten Zeitpunkt gemessen, nämlich dann, wenn die Batterie voll geladen ist. Auf diese Weise sind die gewonnenen Messwerte, nachdem sie temperaturkompensiert wurden, direkt miteinander vergleichbar.

Diese Messung wird in der Regel nach einem Akkumulatorwechsel durchgeführt, sobald der Akkumulator voll geladen ist. Das Messergebnis des Innenwiderstandes wird langfristig gespeichert. Später wird der Innenwiderstand in größeren Abständen von typischerweise einigen Wochen gemessen, temperaturkompensiert und mit dem anfangs gemessenen und gespeicherten Wert verglichen. Vergrößert sich der aktuelle Messwert, beispielsweise um einen Faktor 2 oder 3, gegenüber dem Initialwert, wird angenommen, dass sich die Kapazität soweit verkleinert hat, dass der Akkumulator unbrauchbar ist.

Die Erfinder haben jedoch durch Untersuchungen an BleiAkkumulatoren überraschend festgestellt, dass die Unbrauchbarkeit eines Akkumulators nicht immer an einem erhöhten Innenwiderstand in vollgeladenem Zustand erkannt werden kann. Bei Akkumulatoren, die sehr viele Zyklen bei erhöhter Temperatur geleistet haben, kommt es vor, dass ein vollgeladener Akkumulator durch das Messen des Innenwiderstandes zunächst als brauchbar eingestuft wird, sich bei der Entladung dann aber herausstellt, dass der Akkumulator eine oder mehrere defekte Zellen aufweist, und während der Entladung Überhöhungen des Innenwiderstandes auftreten, aufgrund derer eine Entladung mit höheren Strömen nicht mehr möglich ist. Bei einem solchen Akkumulator ist typischerweise auch die Restkapazität bereits deutlich gesunken, beispielsweise auf einen Wert unter 70 % der Anfangskapazität, so dass der Akkumulator als unbrauchbar eingestuft werden muss. Ein solcher Defekt kann am Verlauf des Innenwiderstandes während der Auf- und/oder Entladung erkannt werden, nicht aber am Innenwiderstand in voll geladenem Zustand allein.

Dementsprechend sieht die Erfindung ein Verfahren zum Überwachen der Funktionsfähigkeit eines Akkumulators vor, welches vorsieht, wenigstens zwei Werte des Innenwiderstandes des Akkumulators in unterschiedlichen teilgeladenen Zuständen während des Ladens und/oder während des Entladens des Akkumulators sowie den jeweils zugeordneten Ladezustand des Akkumulators zu ermitteln, wobei vorzugsweise eine Ladestrom- und Entladestrombilanzierung durchgeführt wird, um jeweils den aktuellen Ladezustand des Akkumulators zu ermitteln. Ferner sieht das Verfahren vor, in Abhängigkeit der ermittelten Werte des Innenwiderstandes und der zugeordneten Ladezustände die Funktionsfähigkeit des Akkumulators zu bestimmen.

Insbesondere wird der Innenwiderstand während des Ladens und/oder während des Entladens des Akkumulators auf einen untypischen Verlauf hin überwacht, welcher auf einen Defekt des Akkumulators hinweist. Ein solcher untypischer Verlauf kann beispielsweise bei einem Abfall des Innenwiderstandes während einer Entladung erkannt werden, da der Innenwiderstand eines voll funktionsfähigen Akkumulators während einer Entladung kontinuierlich ansteigt. Bei einer Entladung eines voll funktionsfähigen Akkumulators steigt der Innenwiderstand zunächst nur leicht an, und erst zum Kapazitätsende hin tritt ein starker Anstieg des Innenwiderstandes auf. Daher kann ein untypischer Verlauf auch dann erkannt werden, wenn sich aus den ermittelten Werten des Innenwiderstandes ein starker Anstieg des Innenwiderstandes deutlich vor Erreichen des Kapazitätsendes ergibt. Bei Erkennen eines untypischen Verlaufes des Innenwiderstandes des Akkumulators auf Grundlage der ermittelten Werte des Innenwiderstandes und der zugeordneten Ladezustände wird der Akkumulator vorzugsweise als nicht ausreichend funktionsfähig erkannt.

Vorteilhaft kann ein untypischer Verlauf erst dann erkannt werden, wenn der Abfall des Innenwiderstandes ein vorgegebenes Maß überschreitet, beispielsweise wenn, während einer Entladung des Akkumulators, ein für einen zweiten Ladezustand ermittelter Wert des Innenwiderstands um einen vorgegebenen prozentualen Anteil gegenüber einem für einen ersten Ladezustand ermittelten Wert des Innenwiderstands abfällt, wobei der Akkumulator im zweiten Ladezustand gegenüber dem ersten Ladezustand stärker entladen ist. Analog kann ein untypischer Verlauf erst dann erkannt werden, wenn ein Anstieg des Innenwiderstandes deutlich vor Erreichen des Kapazitätsendes ein vorgegebenes Maß überschreitet.

Vorteilhaft sieht das Verfahren vor, wenigstens einen Vergleichswert bereitzustellen, wenigstens einen ermittelten Wert des Innenwiderstandes und/oder wenigstens eine daraus abgeleitete Größe mit dem wenigstens einen Vergleichswert zu vergleichen und in Abhängigkeit des Vergleichsergebnisses die Funktionsfähigkeit des Akkumulators zu bestimmen.

Die Funktionsfähigkeit des Akkumulators kann auch dadurch bestimmt werden, dass wenigstens ein Wert des Innenwiderstandes des Akkumulators in einem teilgeladenen Zustand während des Ladens und/oder während des Entladens des Akkumulators sowie der jeweils zugeordnete Ladezustand des Akkumulators ermittelt wird, und der wenigstens eine ermittelte Wert des Innenwiderstandes und/oder wenigstens eine daraus abgeleitete Größe mit wenigstens einem bereitgestellten Vergleichswert verglichen wird, wobei die Funktionsfähigkeit des Akkumulators in Abhängigkeit des Vergleichsergebnisses bestimmt wird.

Für die Ladestrom- und Entladestrombilanzierung zum Ermitteln des aktuellen Ladezustands des Akkumulators, kurz Ladungsbilanzierung genannt, können an sich bekannte Ladungsbilanzierungsmethoden angewendet werden, wobei zu diesem Zweck vorzugsweise Kennwerte des zu überwachenden Akkumulatortyps in einem Speicher hinterlegt werden, die bei der Lade- und Entladestrombilanzierung zusammen mit einem gemessenen, aktuellen Akkumulatorstrom, der aktuellen Akkumulatortemperatur und/oder der aktuellen Akkumulatorspannung verwendet werden, um daraus den aktuellen Ladezustand zu ermitteln. Bei den Kennwerten des Akkumulators kann es sich um die Nennspannung, die Lebensdauer, die Nennkapazität, die Innenwiderstandscharakteristik, das Temperaturverhalten und weitere Parameter handeln. Diese Werte werden vorab mithilfe zahlreicher Messreihen ermittelt und zur Durchführung des Verfahrens mitberücksichtigt.

Die vorliegende Erfindung kann vorzugsweise in industriellen Anlagen zum Einsatz kommen, in denen USV-Geräte (unterbrechungsfreie Stromversorgungen, USV) eingesetzt werden. USV-Geräte sorgen im Falle eines Stromausfalls dafür, dass Teile der Anlage und deren Steuerung für eine bestimmte Zeit weiter betreiben und dann definiert heruntergefahren werden können. Eine genaue Kenntnis über die Funktionsfähigkeit eines in einem USV-Gerät eingesetzten Akkumulators ist deshalb erforderlich, da es bei einem defekten Akkumulator zu einer fehlerhaften Kalkulation der Akkumulatorlaufzeit kommen kann, wodurch die Akkumulatorspannung der USV ausfallen kann, bevor der Verbraucher heruntergefahren ist.

Der Vergleichswert repräsentiert insbesondere einen Referenzwert eines Akkumulators in voll funktionsfähigem Zustand, beispielsweise einen typischen Wert des Innenwiderstandes bei einem vorgegebenen Ladezustand oder eine aus einer Kennlinie des Innenwiderstandes in Abhängigkeit des Ladezustands abgeleitete Größe, wie beispielsweise die Steigung einer solchen Kennlinie bei einem vorgegebenen Ladezustand oder die mittlere Steigung der Kennlinie.

Erfindungsgemäß wird eine Mehrzahl von Werten des Innenwiderstandes ermittelt, vorzugsweise zu vorgegebenen Zeitpunkten während eines Lade- und/oder Entladevorgangs, insbesondere zyklisch, und/oder bei vorgegebenen Ladezuständen des Akkumulators.

Auf diese Weise kann eine Messkurve des Innenwiderstandes des Akkumulators in Abhängigkeit des Ladezustands während eines Lade- und/oder Entladevorgangs aufgenommen und gespeichert werden. Erfindungsgemäß wird eine so ermittelte Messkurve mit einer Kennlinie verglichen, welche den Verlauf des Innenwiderstandes eines voll funktionsfähigen Akkumulators in Abhängigkeit des Ladezustands repräsentiert. Zum Bereitstellen einer solchen Kennlinie wird beispielsweise einmalig eine Referenzmessung eines vollfunktionsfähigen Akkumulators gleichen Typs durchgeführt und die Kennlinie in einem Speicher gespeichert, auf den eine zur Ausführung des Verfahrens ausgebildete Mess- und Auswerteeinrichtung zugreifen kann. Eine oder mehrere ermittelte Messkurven können zudem vorteilhaft für eine spätere Analyse dauerhaft gespeichert werden.

Die Funktionsfähigkeit des Akkumulators kann vorteilhaft auch direkt aus dem Verlauf der Messkurve ohne einen Vergleich mit einer hinterlegten Kennlinie bestimmt werden, insbesondere durch Erkennen charakteristischer, auf einen Defekt hinweisender Eigenschaften, wie beispielsweise einen Abfall des Innenwiderstandes während einer Entladung oder einen frühzeitigen starken Anstieg des Innenwiderstandes während einer Entladung.

Um eine Temperaturabhängigkeit zu berücksichtigen, können vorzugsweise eine Mehrzahl von Kennlinien bereitgestellt werden, welche den Verlauf des Innenwiderstandes eines voll funktionsfähigen Akkumulators in Abhängigkeit des Ladezustands bei jeweils unterschiedlichen Temperaturen des Akkumulators repräsentieren. In diesem Fall sieht das Verfahren vorzugsweise vor, zu jedem ermittelten Wert des Innenwiderstandes des Akkumulators auch die Temperatur des Akkumulators zu ermitteln und in Abhängigkeit der Temperatur jeweils eine der Kennlinien für einen Vergleich auszuwählen. Alternativ kann eine Kennlinien für eine normierte Temperatur bereitgestellt werden, wobei vorzugsweise die ermittelten Werte des Innenwiderstandes des Akkumulators auf diese normierte Temperatur umgerechnet werden.

Zum Ermitteln einer Abweichung der ermittelten Werte des Innenwiderstandes von den gespeicherten Referenzwerten bzw. Referenz-Kennlinien werden vorzugsweise jeweils Messwerte mit Referenzwerten verglichen, denen der im Wesentlichen gleiche Akkumulator-Ladezustand zugeordnet ist, wobei zum Vergleichen vorzugsweise eine Differenz oder ein Quotient des jeweiligen Mess- und Referenzwerts gebildet wird. Vorteilhaft können auch aus einer Mehrzahl von Messwerten abgeleitete Größen mit einem Referenzwert verglichen werden, beispielsweise kann aus wenigstens zwei bei unterschiedlichen Ladezuständen ermittelten Werten des Innenwiderstandes des Akkumulators eine Steigung ermittelt und mit einem gespeicherten Referenzwert für die Steigung verglichen werden, wobei zu diesem Zweck insbesondere eine ermittelte und gespeicherte Messkurve differenziert werden kann, um so die Steigung der Messkurve in Abhängigkeit des Ladezustands zu ermitteln.

Aus den ermittelten Abweichungen zwischen Mess- und Referenzwerten wird die Funktionsfähigkeit des Akkumulators ermittelt, wobei der Akkumulator insbesondere als nicht ausreichend funktionsfähig erkannt wird, wenn das Vergleichsergebnis, d.h. eine ermittelte Abweichung der Messwerte von gespeicherten Referenzwerten, einen vorgegebenen Schwellwert überschreitet.

Beispielsweise kann eine nicht ausreichende Funktionsfähigkeit des Akkumulators erkannt werden, wenn für eine vorgegebene Anzahl von Messwerten einer Messkurve des Innenwiderstandes in Abhängigkeit des Ladezustands der Messwert um einen vorgegebenen Faktor, beispielsweise 2, von dem jeweils zugeordneten Referenzwert einer gespeicherten Kennlinie abweicht.

Der bereitgestellte Vergleichswert, d.h. der Referenzwert, kann auch gleichzeitig als Schwellwert dienen. So kann beispielsweise eine nicht ausreichende Funktionsfähigkeit des Akkumulators erkannt werden, wenn die Steigung einer ermittelten Messkurve wenigstens abschnittsweise einen gespeicherten Vergleichswert überschreitet.

Vorteilhaft kann die Funktionsfähigkeit des Akkumulators insbesondere auch aus einem einzelnen Wert für die Steigung des Innenwiderstandes in Abhängigkeit des Ladezustands bestimmt werden, wobei der Steigungswert für einen zugeordneten Ladezustand insbesondere aus wenigstens zwei bei unterschiedlichen Ladezuständen ermittelten Werten des Innenwiderstandes des Akkumulators oder durch Differenzieren einer Messkurve des Innenwiderstandes in Abhängigkeit des Ladezustands ermittelt wird, da bereits auf Grundlage eines einzelnen Steigungswertes für einen zugeordneten Ladezustand ein untypischer Verlauf des Innenwiderstandes und damit eine nicht ausreichende Funktionsfähigkeit des Akkumulators erkannt werden kann.

Typischerweise umfasst ein Akkumulator eine Mehrzahl von Zellen, wobei diese Zellen jeweils individuell einen beispielsweise durch Abnutzung verursachten Defekt aufweisen können. Daher ist in einer besonders bevorzugten Ausführungsform des Verfahrens vorgesehen, dass durch Auswerten des Verlaufs einer durch eine Mehrzahl von bei unterschiedlichen Ladezuständen ermittelten Werten des Innenwiderstandes des Akkumulators gebildete Messkurve ein Defekt wenigstes einer Zelle des Akkumulators erkannt wird, insbesondere durch Erkennen einer auch als Peak bezeichneten Spitze in einer Messkurve oder in einer durch die Differenz einer Messkurve mit einer gespeicherten Kennlinie gebildeten Kurve, d.h. eines plötzlichen Anstiegs und Abfalls der jeweiligen Kurve. Besonders vorteilhaft können zusätzlich weitere Parameter eines erkannten Peaks ermittelt werden, wie beispielsweise der Scheitelfaktor, d.h. das Verhältnis von Peakhöhe zum Mittelwert des Peaks.

Die Funktionsfähigkeit des Akkumulators kann derart ermittelt werden, dass als Ergebnis die Information bereitgestellt wird, ob der Akkumulator noch ausreichend funktionsfähig ist oder nicht, wobei eine ausreichende Funktionsfähigkeit vom Einsatzzweck abhängen kann.

Es kann vorteilhaft auch ein Maß für die Funktionsfähigkeit des Akkumulators ermittelt werden, beispielsweise in Form eines SOH (State of Health) des Akkumulators, dessen Wert zwischen 0 % und 100 % liegt. In einer vorteilhaften Ausführungsform gehen in die Ermittlung eines SOH des Akkumulators, zusätzlich zu den Ergebnissen einer Auswertung des Verlaufs des Innenwiderstands des Akkumulators während des Ladens und/oder Entladens, insbesondere eines Vergleichs mit zugeordneten Referenzwerten, noch Ergebnisse weiterer Messungen und/oder Auswertungen und/oder weitere Parameter mit vorgegebenen Gewichtungen ein.

Vorteilhaft wird die ermittelte Funktionsfähigkeit des Akkumulators einem Benutzer mittels einer geeigneten Anzeigeeinrichtung, wie beispielsweise einer Leuchtdiode oder einem Display angezeigt, um den Benutzer über eine mangelnde Funktionsfähigkeit des Akkumulators zu informieren, damit dieser den Akkumulator wechseln kann.

Ein Kerngedanke der vorliegenden Erfindung ist darin zu sehen, dass anders als bei bekannten Verfahren zum Ermitteln der Funktionsfähigkeit eines Akkumulators, insbesondere eines SOH, bei welchen jeweils Betriebsereignisse erfasst werden, die anhand von Berechnungen und Vergleichen mit Datenblattangaben zu Werten des SOH führen, die für den jeweiligen Akkumulator typisch sind, erfindungsgemäß mit dem Innenwiderstand des Akkumulators während des Ladens und/oder Entladens ein Parameter des Akkumulators gemessen wird, welcher direkt zu einem tatsächlichen SOH des individuellen überwachten Akkumulator-Exemplars führt.

Angemerkt sei, dass Lade- und/oder Entladevorgänge vorzugsweise nicht speziell für Messzwecke erzwungen werden, sondern sich aus dem normalen Akkumulatorbetrieb ergeben.

Das oben genannte technische Problem wird ebenfalls durch eine Vorrichtung mit den Merkmalen des Anspruchs 11 gelöst. Eine Vorrichtung zum Überwachen der Funktionsfähigkeit eines Akkumulators umfasst einen Spannungsdetektor zum Detektieren der aktuellen Akkumulatorspannung, einen Stromdetektor zum Detektieren des aktuellen Akkumulatorstroms, und eine Mess- und Auswerteeinrichtung zum Ermitteln wenigstens zweier Werte des Innenwiderstandes des Akkumulators in unterschiedlichen teilgeladenen Zuständen während des Ladens und/oder während des Entladens des Akkumulators und zum Ermitteln des dem jeweils ermittelten Wert des Innenwiderstandes zugeordneten Ladezustands des Akkumulators, wobei die Mess- und Auswerteeinrichtung dazu ausgebildet ist, eine Ladestrom- und Entladestrombilanzierung zum Ermitteln des aktuellen Ladezustands des Akkumulators durchzuführen und in Abhängigkeit der ermittelten Werte des Innenwiderstandes und der zugeordneten Ladezustände die Funktionsfähigkeit des Akkumulators zu bestimmen.

Vorteilhaft umfasst die Vorrichtung ferner eine Speichereinrichtung, in welcher wenigstens ein Vergleichswert gespeichert ist, wobei die Mess- und Auswerteeinrichtung dazu ausgebildet ist, wenigstens einen ermittelten Wert des Innenwiderstandes und/oder wenigstens eine daraus abgeleitete Größe mit einem zugeordneten gespeicherten Vergleichswert zu vergleichen und die Funktionsfähigkeit des Akkumulators in Abhängigkeit des Vergleichsergebnisses zu bestimmen.

Die Mess- und Auswerteeinrichtung kann auch zum Ermitteln wenigstens eines Wertes des Innenwiderstandes des Akkumulators in einem teilgeladenen Zustand während des Ladens und/oder während des Entladens des Akkumulators und zum Ermitteln des dem jeweils ermittelten Wert des Innenwiderstandes zugeordneten Ladezustands des Akkumulators vorgesehen und dazu ausgebildet sein, den wenigstens einen ermittelten Wert des Innenwiderstandes und/oder wenigstens eine daraus abgeleitete Größe mit einem zugeordneten gespeicherten Vergleichswert zu vergleichen und die Funktionsfähigkeit des Akkumulators in Abhängigkeit des Vergleichsergebnisses zu bestimmen.

Vorteilhaft ist die Vorrichtung zum Durchführen des oben beschriebenen Verfahrens ausgebildet. Dementsprechend ist die Mess- und Auswerteeinrichtung vorzugsweise dazu ausgebildet ist, zu vorgegebenen Zeitpunkten, insbesondere zyklisch, und/oder zu vorgegebenen Ladezuständen des Akkumulators Werte des Innenwiderstandes des Akkumulators zu ermitteln.

Erfindungsgemäß ist in der Speichereinrichtung wenigstens eine Kennlinie gespeichert, welche den Verlauf des Innenwiderstandes eines voll funktionsfähigen Akkumulators in Abhängigkeit des Ladezustands repräsentiert. Zur Berücksichtigung einer Temperaturabhängigkeit des Innenwiderstandes können vorteilhaft auch eine Mehrzahl von Kennlinien in der Speichereinrichtung gespeichert sind, welche den Verlauf des Innenwiderstandes eines voll funktionsfähigen Akkumulators in Abhängigkeit des Ladezustands bei jeweils unterschiedlichen Temperaturen des Akkumulators repräsentieren, wobei in diesem Fall die Vorrichtung vorzugsweise einen Temperaturdetektor zum Messen der aktuellen Akkumulatortemperatur umfasst.

Die Mess- und Auswerteeinrichtung ist ferner vorteilhaft dazu ausgebildet, eine Differenz und/oder einen Quotienten eines ermittelten Wertes des Innenwiderstandes des Akkumulators und eines in der Speichereinrichtung gespeicherten zugeordneten Vergleichswertes zu ermitteln und/oder eine Steigung aus wenigstens zwei bei unterschiedlichen Ladezuständen ermittelten Werten des Innenwiderstandes des Akkumulators zu ermitteln.

Die Erfindung ist jedoch nicht hierauf beschränkt, sondern umfasst auch weitere Berechnungs- bzw. Analysevarianten, die geeignet sind, ermittelte Messwerte bzw. Messkurven mit Referenzwerten bzw. Referenz-Kennlinien zu vergleichen, um ein Maß für eine Abweichung zu ermitteln. Ferner umfasst die Erfindung auch Berechnungs- bzw. Analysevarianten, die geeignet sind, ermittelte Messwerte oder Messkurven ohne einen Vergleich mit Referenzwerten oder Referenz-Kennlinien auszuwerten, um untypische Werte oder untypische Kurvenverläufe und damit eine nicht ausreichende Funktionsfähigkeit des Akkumulators zu erkennen.

Erfindungsgemäß ist die Mess- und Auswerteeinrichtung dazu ausgebildet, durch Auswerten des Verlaufs einer durch eine Mehrzahl von bei unterschiedlichen Ladezuständen ermittelten Werten des Innenwiderstandes des Akkumulators gebildeten Messkurve einen Defekt wenigstes einer Zelle des Akkumulators zu erkennen, insbesondere durch Erkennen und Analysieren eines Peaks in einer Messkurve oder erfindugsgemäß in einer durch die Differenz einer Messkurve mit einer gespeicherten Kennlinie gebildeten Kurve.

Das oben genannte technische Problem wird ebenfalls mit einer unterbrechungsfreien Stromversorgung gelöst, welche die oben beschriebene Vorrichtung umfasst.

Die Erfindung wird nachfolgend beispielhaft anhand bevorzugter Ausführungsformen und unter Bezugnahme auf die beigefügten Zeichnungen genauer beschrieben. Dabei bezeichnen gleiche Bezugszeichen in den Zeichnungen gleiche oder ähnliche Teile.

Es zeigen:
- Fig. 1:: schematisch den prinzipiellen Aufbau einer unterbrechungsfreie Stromversorgung, in welcher die Erfindung verwirklicht ist,
- Fig. 2:: einen beispielhaften Verlauf der Spannung und des Innenwiderstands eines neuen Akkumulators während eines Entladevorgangs,
- Fig. 3:: einen beispielhaften Verlauf der Spannung und des Innenwiderstands eines ersten defekten Akkumulators während eines Entladevorgangs, und
- Fig. 4:: einen beispielhaften Verlauf der Spannung und des Innenwiderstands eines zweiten defekten Akkumulators während eines Entladevorgangs.

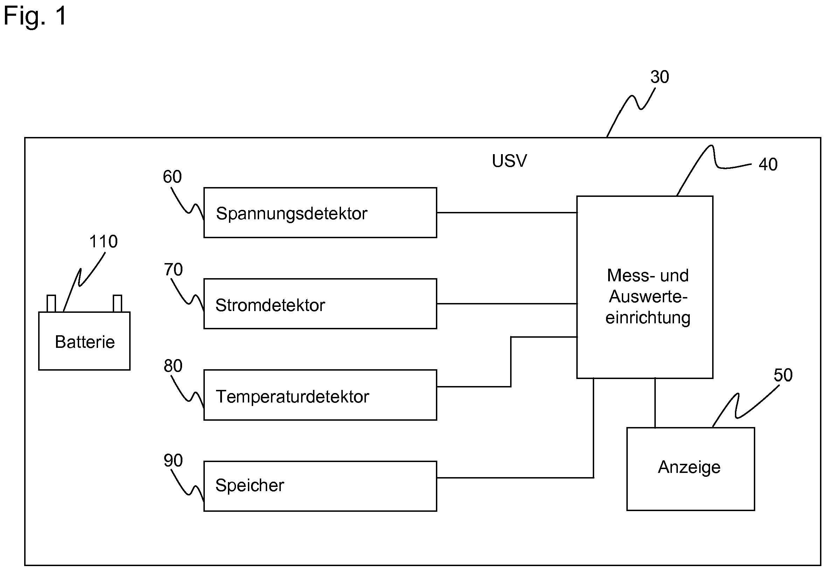

Fig. 1 zeigt ein beispielhaftes USV-Gerät 30, d.h. eine unterbrechungsfreie Stromversorgung, die in an sich bekannter Weise einen wiederaufladbaren Akkumulator 110 enthält. Mit dem USV-Gerät 30 können bei Stromausfall elektrische Geräte oder Anlagen vorübergehend weiter mit Energie versorgt und anschließend sicher heruntergefahren werden. Zur Überwachung des Akkumulators 110 weist das USV-Gerät 30 mehrere Sensoren oder Detektoren, wie zum Beispiel einen Spannungsdetektor 60, einen Stromdetektor 70 und einen Temperaturdetektor 80 auf. Der Spannungsdetektor 60 misst zu einstellbaren Zeitpunkten oder kontinuierlich die aktuelle Akkumulatorspannung. Der Stromdetektor 70 misst zu einstellbaren Zeitpunkten oder kontinuierlich den aktuellen Akkumulatorstrom. Je nach Akkumulatorbetrieb entspricht der Akkumulatorstrom dem Entladestrom oder dem Ladestrom. Mit dem Temperaturdetektor 80 wird zu einstellbaren Zeitpunkten oder kontinuierlich die Akkumulatortemperatur gemessen. Die gemessenen Werte der Detektoren 60, 70 und 80 werden einer Mess- und Auswerteeinrichtung 40 zugeführt. Im dargestellten Ausführungsbeispiel ist ein Speicher 90 vorgesehen, in welchem wenigstens ein Vergleichswert gespeichert ist, welcher insbesondere einen Referenzwert eines Akkumulators in voll funktionsfähigem Zustand repräsentiert.

In den Speicher 90 werden ferner vorzugsweise Kennwerte des Akkumulators 110 geladen, zum Beispiel während einer Initialisierungsphase. Angemerkt sei, dass die im Speicher 90 abgelegten Kennwerte des Akkumulators zuvor mithilfe einer Reihe von Messdurchläufen an einem Akkumulatortyp, welcher dem Akkumulator 110 entspricht, bestimmt worden sind. Die Inhalte des Speichers 90 können von der Mess- und Auswerteeinrichtung 40 ausgelesen werden. Über eine Anzeigeeinrichtung 50 können die von der Mess- und Auswerteeinrichtung 40 ermittelten Ergebnisse optisch ausgegeben werden.

Die Steuer- und Auswerteeinrichtung 40 ist zur Durchführung einer Ladungsbilanzierung und zur Überwachung der Funktionsfähigkeit des Akkumulators 110 ausgebildet.

Zur Durchführung einer Ladungsbilanzierung erfolgt eine Messung des Akkumulatorstroms, der Akkumulatorspannung und der Akkumulatortemperatur mittels des Stromdetektors 70, des Spannungsdetektors 60 bzw. des Temperaturdetektors 80. Die aktuellen Messwerte werden von den Detektoren 60 bis 80 der Mess- und Auswerteeinrichtung 40 zugeführt. Die Mess- und Auswerteeinrichtung 40 ermittelt aus den im Speicher 90 gespeicherten Kennwerten des Akkumlators und den von den Detektoren 60 bis 80 gelieferten aktuellen Messwerten jeweils Korrekturwerte für die aktuelle Ladung. Die Steuer- und Auswerteeinrichtung 40 kann entsprechende Kennlinien, die im USV-Gerät 30 gespeichert sind, verwenden, um die Korrekturwerte zu ermitteln. Die Korrekturwerte und Messwerte können in jedem Ladungsbilanzierungszyklus aktualisiert werden. Ferner kann eine Initialisierung vorgesehen sein, bei welcher die Kennwerte des Akkumulators eingelesen und im Speicher 90 abgelegt werden sowie ein Anfangswert des Ladungszustands festgelegt wird.

Die Mess- und Auswerteeinrichtung 40 ist vorteilhafter Weise derart ausgebildet, dass sie in Abhängigkeit von der ermittelten aktuellen Akkumulatorladung den Shutdown eines an das USV-Gerät 30 angeschlossenen Verbrauchers so rechtzeitig auslöst, dass dieser noch sicher heruntergefahren werden kann. Erst nach dem Shutdown sollte die aktuelle Akkumulatorspannung unter die Entladeschlussspannung sinken.

Zur Überwachung der Funktionsfähigkeit des Akkumulators 110 wird in vorgegebenen Zeitabständen während des Ladens und/oder während des Entladens des Akkumulators 110 der Innenwiderstand des Akkumulators 110 ermittelt und im Speicher 90 zusammen mit dem jeweils aktuellen Ladezustand des Akkumulators 110 gespeichert.

Der Innenwiderstand kann beispielsweise mittels einer Messmethode ermittelt werden, bei welcher der Akkumulatorspannung eine kleine Wechselspannung mit konstanter Frequenz, beispielsweise 100 Hz, überlagert und dann mittels des Stromdetektors 70 der Akkumulatorwechselstrom gemessen wird. Der Innenwiderstand kann anschließend von der Mess- und Auswerteeinrichtung 40 gemäß der Gleichung R_{I}=U_{EFF}/I_{EFF} berechnet werden.

Gemäß einem alternativen Messverfahren werden dem Akkumulator 110 nacheinander zwei Gleichströme entzogen und daraus die entsprechenden Akkumulatorspannungen gemessen. Der Innenwiderstand ergibt sich dann gemäß der Gleichung R_{I}=ΔU/ΔI. Um Temperatureinflüsse des Innenwiderstandes eliminieren zu können, wird der Messwert des Innenwiderstandes zusammen mit dem Messwert der aktuellen Akkumulatortemperatur auf einen Widerstandswert bei einer normierten Temperatur umgerechnet. Es sind zahlreiche weitere Verfahren zum Berechnen des Innenwiderstandes eines Akkumulators bekannt, welche ebenfalls zum Ermitteln des Innenwiderstandes des Akkumulators 110 eingesetzt werden können.

Die durch die gemessenen normierten Werte des Innenwiderstandes gebildete Messkurve wird von der Mess- und Auswerteeinrichtung 40 mit einer im Speicher 90 gespeicherten, korrespondierend normierten Kennlinie verglichen, welche den Verlauf des Innenwiderstandes eines voll funktionsfähigen Akkumulators in Abhängigkeit des Ladezustands repräsentiert.

Aus den bei diesem Vergleich ermittelten Abweichungen bestimmt die Mess- und Auswerteeinrichtung 40 ein Maß für die Funktionsfähigkeit des Akkumulators 110 und zeigt das Ergebnis mittels der Anzeigeeinrichtung 50 an, wobei eine mangelnde Funktionsfähigkeit insbesondere dann festgestellt wird, wenn die ermittelten Abweichungen einen im Speicher 90 hinterlegten Schwellwert überschreiten.
Alternativ kann von der Mess- und Auswerteeinrichtung 40 ein Maß für die Funktionsfähigkeit des Akkumulators 110 auch direkt aus den gemessenen normierten Werten des Innenwiderstandes ohne einen Vergleich mit gespeicherten Referenzwerten oder Kennlinien bestimmt werden.

Ein Defekt des Akkumulators 110, insbesondere einzelner Zellen des Akkumulators 110, kann insbesondere durch Erkennen von Peaks in einer ermittelten Messkurve festgestellt werden. Insbesondere kann eine nicht ausreichende Funktionsfähigkeit des Akkumulators während einer Entladung an einem Abfall des Innenwiderstandes oder an einem starken Anstieg des Innenwiderstandes deutlich vor Erreichen des Kapazitätsendes erkannt werden.

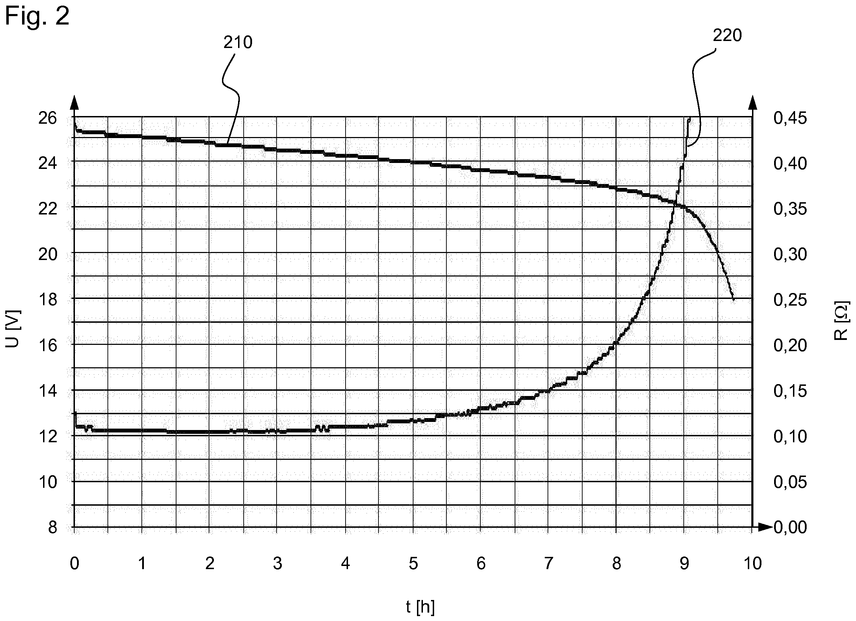

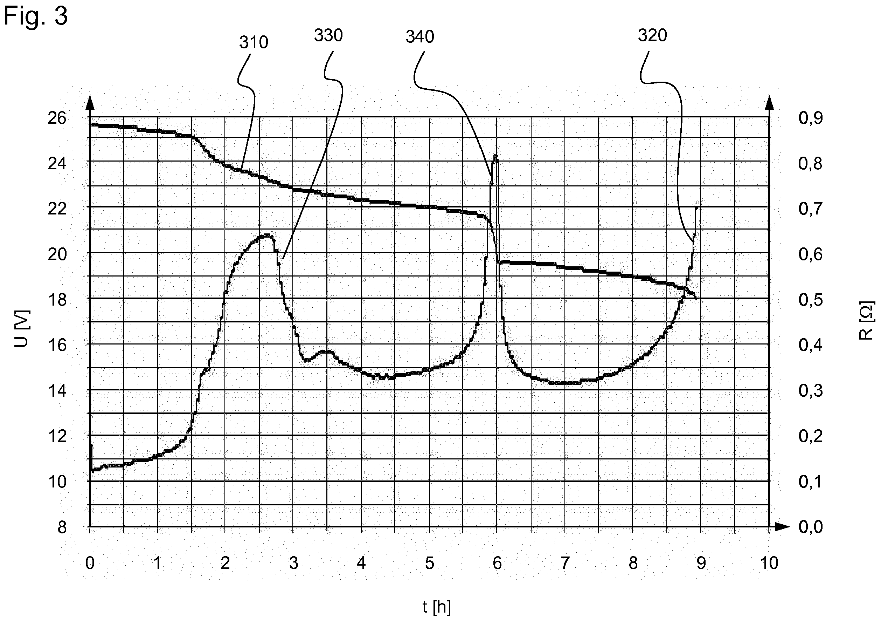

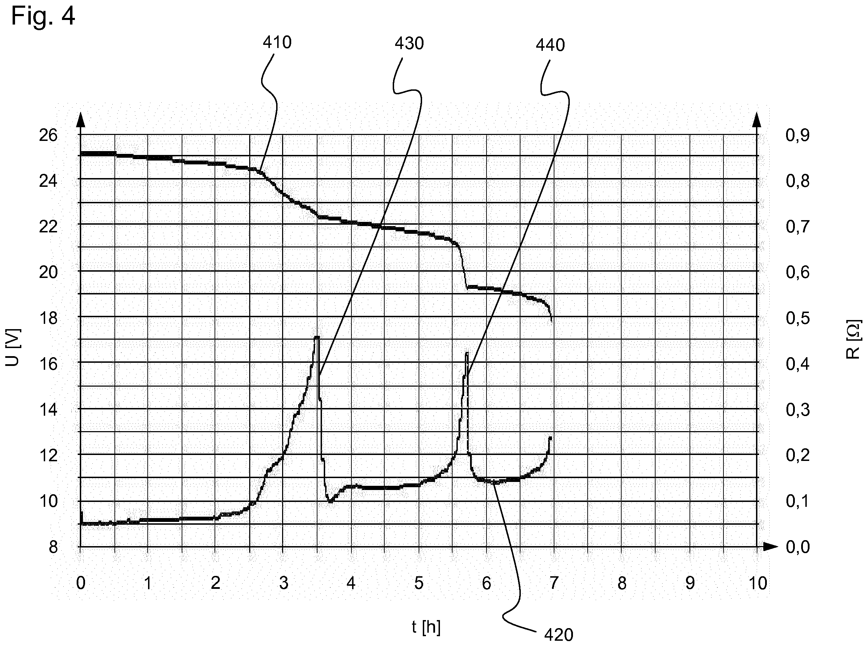

Fig. 2 zeigt den Verlauf der Spannung und des Innenwiderstands eines neuen Akkumulators, während in den Figuren 3 und 4 entsprechende Verläufe für zwei Beispiele defekter Akkumulatoren dargestellt sind, in welchen Peaks auftreten, die auf einen Defekt einer oder mehrerer Zellen hinweisen.

In Fig. 2 ist in Abhängigkeit der Zeit die Spannung 210 und der Innenwiderstand 220 eines neuen, nahezu voll funktionsfähigen Akkumulators mit einer Nennspannnung von 24 V und einer Nennkapazität von 3,4 Ah während einer Entladung mit einem konstanten Entladestrom von 340 mA dargestellt. Aufgrund des konstanten Entladestroms korrespondieren die dargestellten Kurvenverläufe in Abhängigkeit der Zeit mit entsprechenden Verläufen in Abhängigkeit des Ladezustands des Akkumulators. Wie der Fig. 2 zu entnehmen ist, dauert es bis zum Erreichen der Entladeschlussspannung von 19,2 V etwa 9,58 Stunden. Dies entspricht einer Kapazität von 9,58 Stunden * 0,34 A = 3,26 Ah. Dieser Akkumulator ist noch neu und gut brauchbar. Der Innenwiderstand 220 wächst mit zunehmender Entladung von 0,1 Ω bis 0,5 Ω.

In Fig. 3 ist in Abhängigkeit der Zeit die Spannung 310 und der Innenwiderstand 320 eines Akkumulators mit einer Nennspannnung von 24 V und einer Nennkapazität von 3,4 Ah während einer Entladung mit einem konstanten Entladestrom von 340 mA dargestellt, wobei der Akkumulator bereits 170 Lade- und Entladezyklen durchlaufen hat. Aufgrund des konstanten Entladestroms korrespondieren die dargestellten Kurvenverläufe in Abhängigkeit der Zeit wiederum mit entsprechenden Verläufen in Abhängigkeit des Ladezustands des Akkumulators. Wie der Fig. 3 zu entnehmen ist, weist der Akkumulator nur noch eine Restkapazität von 2,38 Ah auf, also etwa 70 % der Neukapazität. Der Akkumulator ist damit unbrauchbar. Der Innenwiderstand wächst von etwa 0,1 Ω bis etwa 0,8 Ω, allerdings auf eine Art und Weise, die erkennen lässt, dass in dem Akkumulator einzelne Zellen bereits defekt sind. Dies ist insbesondere an den Peaks 330 und 340 erkennbar, welche durch die Mess- und Auswerteeinrichtung 40 durch Vergleichen mit einer Kennlinie, welche im Wesentlichen dem in Fig. 2 dargestellten Verlauf des Innenwiderstands entspricht, erkannt wird. Im dargestellten Ausführungsbeispiel besteht der Akkumulator aus 12 Zellen, die in Reihe geschaltet sind. Bei einem frischen, voll funktionsfähigen Akkumulator haben alle Zellen die gleiche Kapazität, werden also gleich schnell geladen und entladen. Ist eine Zelle nach vielen Lade- und Entladezyklen defekt und verliert besonders stark ihre Kapazität, so verliert der Akkumulator bei einer Entladung bereits nach kurzer Zeit eine Zellenspannung. Wie der Fig. 3 zu entnehmen ist, sinkt die Spannung bei der Entladung relativ schnell um 2 V ab, und zwar innerhalb der ersten zwei Stunden der Entladung, während der Innenwiderstand stark ansteigt. Wenn die defekte Zelle leer ist, fällt der Innenwiderstand relativ schnell auf etwas mehr als den Initialwiderstand ab und es zeigt sich der charakteristische Peak 330 im Verlauf des Innenwiderstandes. Entsprechend weist der Peak 340 auf eine zweite defekte Zelle hin.

Ein aufgrund wenigstens einer defekten Zelle nicht ausreichend funktionsfähiger Akkumulator kann somit insbesondere während einer Entladung an einem stark ansteigenden Innenwiderstand weit vor dem Kapazitätsende und/oder an einem fallenden Innenwiderstand erkannt werden.

Es ist anzumerken, dass die Messung des Innenwiderstandes bei voll geladenem Akkumulator, welche in dem in Fig. 3 dargestellten Beispiel einen Wert von etwa 0,18 Ω liefert, und Vergleichen mit dem entsprechenden von etwa 0,125 Ω eines neuen Akkumulators noch keinen Aufschluss über die Unbrauchbarkeit des Akkumulator gibt. Erst der Verlauf des Innenwiderstandes über die Entladung des Akkumulators lässt erkennen, dass mindesten zwei Zellen des Akkumulators defekt sind, und der Akkumulator somit unbrauchbar ist.

In Fig. 4 ist in Abhängigkeit der Zeit die Spannung 410 und der Innenwiderstand 420 eines Akkumulators mit einer Nennkapazität von 12 Ah während einer Entladung dargestellt, wobei der Akkumulator bereits 195 Lade- und Entladezyklen durchlaufen hat. Wie der Fig. 4 zu entnehmen ist, weist der Akkumulator nur noch eine Restkapazität von etwa 7 Ah auf, also etwa 58 % der Neukapazität. Der Akkumulator ist damit unbrauchbar. Wiederum ist am Innenwiderstand des voll geladenen Akkumulators der Defekt des Akkumulators nicht zu erkennen. Erst der Verlauf des Innenwiderstandes während der Entladung, insbesondere durch die Peaks 430 und 440, lässt erkennen, dass auch in diesem Akkumulator mindestens zwei Zellen defekt sind.

Der SOH eines Akkumulators kann somit nicht wie derzeit im Stand der Technik angenommen, aus dem Messergebnis des Innenwiderstandes bei voll geladenem Akkumulator erkannt werden.

Die Erfindung sieht daher mit besonderem Vorteil vor, den Verlauf des Innenwiderstandes während einer Entladung zu ermitteln und zu analysieren. Bei der Ladung eines Akkumulators sind ähnlich brauchbare Ergebnisse zu erwarten, wie die in den Figuren 2 bis 4 für eine Entladung dargestellten.

## Patentansprüche

1. Verfahren zum Überwachen der Funktionsfähigkeit eines Akkumulators (110), umfassend die Schritte:
- Ermitteln wenigstens zweier Werte des Innenwiderstandes des Akkumulators (110) in jeweils unterschiedlichen teilgeladenen Zuständen während des Ladens und/oder während des Entladens des Akkumulators (110), wobei zu jedem ermittelten Wert des Innenwiderstandes der jeweilige Ladezustand des Akkumulators (110) ermittelt wird,
und
- Bestimmen der Funktionsfähigkeit des Akkumulators (110) in Abhängigkeit der ermittelten Werte des Innenwiderstandes und der zugeordneten Ladezustände, wobei wenigstens eine Kennlinie bereitgestellt wird, welche den Verlauf des Innenwiderstandes eines voll funktionsfähigen Akkumulators in Abhängigkeit des Ladezustands repräsentiert, und wobei durch Ermitteln einer Mehrzahl von Werten des Innenwiderstandes des Akkumulators eine Messkurve ermittelt wird, welche mit wenigstens einer der bereitgestellten Kennlinien verglichen wird.

2. Verfahren nach Anspruch 1, ferner umfassend die Schritte:
- Bereitstellen wenigstens eines Vergleichswertes, und
- Vergleichen wenigstens eines ermittelten Wertes des Innenwiderstandes und/oder wenigstens einer daraus abgeleiteten Größe mit dem wenigstens einen Vergleichswert, wobei
die Funktionsfähigkeit des Akkumulators (110) in Abhängigkeit des Vergleichsergebnisses bestimmt wird.

3. Verfahren nach einem der vorstehenden Ansprüche, wobei zu vorgegebenen Zeitpunkten, insbesondere zyklisch, und/oder zu vorgegebenen Ladezuständen des Akkumulators (110) Werte des Innenwiderstandes des Akkumulators (110) ermittelt werden.

4. Verfahren nach einem der vorstehenden Ansprüche, wobei jedem bereitgestellten Vergleichswert eine Temperatur zugeordnet wird, wobei insbesondere eine Mehrzahl von Kennlinien bereitgestellt werden, welche den Verlauf des Innenwiderstandes eines voll funktionsfähigen Akkumulators in Abhängigkeit des Ladezustands bei jeweils unterschiedlichen Temperaturen des Akkumulators repräsentieren, und wobei zu jedem ermittelten Wert des Innenwiderstandes des Akkumulators (110) die Temperatur des Akkumulators (110) ermittelt wird.

5. Verfahren nach einem der vorstehenden Ansprüche, wobei wenigstens ein Vergleichswert einen Innenwiderstand eines voll funktionsfähigen Akkumulators bei einem vorgegebenen Ladezustand repräsentiert, und wobei das Vergleichen des wenigstens einen ermittelten Wertes für den Innenwiderstand das Bilden einer Differenz oder eines Quotienten mit einem zugeordneten Vergleichswert umfasst.

6. Verfahren nach einem der vorstehenden Ansprüche, wobei wenigstens ein Vergleichswert eine Steigung einer den Verlauf des Innenwiderstandes eines voll funktionsfähigen Akkumulators in Abhängigkeit des Ladezustands repräsentierenden Kennlinie repräsentiert, und wobei aus den wenigstens zwei bei unterschiedlichen Ladezuständen ermittelten Werten für den Innenwiderstand des Akkumulators (110) eine Steigung ermittelt und mit dem wenigstens einen Vergleichswert verglichen wird.

7. Verfahren nach einem der vorstehenden Ansprüche, wobei der Akkumulator (110) als nicht ausreichend funktionsfähig erkannt wird, wenn das Vergleichsergebnis einen vorgegebenen Schwellwert überschreitet.

8. Verfahren nach einem der vorstehenden Ansprüche, wobei der Akkumulator (110) als nicht ausreichend funktionsfähig erkannt wird, wenn aus den ermittelten Werten des Innenwiderstandes ein während einer Entladung des Akkumulators (110) auftretender Abfall des Innenwiderstandes erkannt wird.

9. Verfahren nach einem der vorstehenden Ansprüche, wobei der Akkumulator (110) eine Mehrzahl von Zellen umfasst, und wobei durch Auswerten des Verlaufs einer durch eine Mehrzahl von bei unterschiedlichen Ladezuständen ermittelten Werten des Innenwiderstandes des Akkumulators (110) gebildete Messkurve ein Defekt wenigstes einer Zelle des Akkumulators (110) erkannt wird.

10. Verfahren nach einem der vorstehenden Ansprüche, wobei eine Ladestrom- und Entladestrombilanzierung durchgeführt wird, um den aktuellen Ladezustand des Akkumulators (110) zu ermitteln.

11. Vorrichtung zum Überwachen der Funktionsfähigkeit eines Akkumulators (110), mit
einer Speichereinrichtung (90), in der wenigstens eine Kennlinie gespeichert ist, welche den Verlauf des Innenwiderstandes eines voll funktionsfähigen Akkumulators in Abhängigkeit des Ladezustands repräsentiert,
einem Spannungsdetektor (60) zum Detektieren der aktuellen Akkumulatorspannung,
einem Stromdetektor (70) zum Detektieren des aktuellen Akkumulatorstroms, und
einer Mess- und Auswerteeinrichtung (40) zum Ermitteln wenigstens zweiter Werte des Innenwiderstandes des Akkumulators (110) in unterschiedlichen teilgeladenen Zuständen während des Ladens und/oder während des Entladens des Akkumulators (110) und zum Ermitteln des dem jeweils ermittelten Wert des Innenwiderstandes zugeordneten Ladezustands des Akkumulators (110), wobei die Mess- und Auswerteeinrichtung (40) dazu ausgebildet ist,
eine Ladestrom- und Entladestrombilanzierung zum Ermitteln des aktuellen Ladezustands des Akkumulators (110) durchzuführen, und in Abhängigkeit der ermittelten Werte des Innenwiderstandes und der zugeordneten Ladezustände die Funktionsfähigkeit des Akkumulators (110) zu bestimmen, wobei die Mess- und Auswerteeinrichtung (40) dazu ausgebildet ist, durch Auswerten des Verlaufs einer durch eine Mehrzahl von bei unterschiedlichen Ladezuständen ermittelten Werten des Innenwiderstandes des Akkumulators (110) gebildeten Messkurve, sowie durch Vergleichen dieser Messkurve mit einer der gespeicherten Kennlinien einen Defekt wenigstes einer Zelle des Akkumulators (110) zu erkennen.

12. Vorrichtung nach Anspruch 11, wobei in der Speichereinrichtung (90) wenigstens ein Vergleichswert gespeichert ist, wobei die Mess- und Auswerteeinrichtung (40) dazu ausgebildet ist, wenigstens einen ermittelten Wert des Innenwiderstandes und/oder wenigstens eine daraus abgeleiteten Größe mit einem zugeordneten gespeicherten Vergleichswert zu vergleichen und die Funktionsfähigkeit des Akkumulators (110) in Abhängigkeit des Vergleichsergebnisses zu bestimmen.

13. Vorrichtung nach einem der Ansprüche 11 oder 12, wobei die Mess- und Auswerteeinrichtung (40) dazu ausgebildet ist, zu vorgegebenen Zeitpunkten, insbesondere zyklisch, und/oder zu vorgegebenen Ladezuständen des Akkumulators (110) Werte des Innenwiderstandes des Akkumulators (110) zu ermitteln.

14. Vorrichtung nach einem der Ansprüche 11 bis 13, wobei eine Mehrzahl von Kennlinien in der Speichereinrichtung (90) gespeichert sind, welche den Verlauf des Innenwiderstandes eines voll funktionsfähigen Akkumulators in Abhängigkeit des Ladezustands bei jeweils unterschiedlichen Temperaturen des Akkumulators repräsentieren und die Vorrichtung (30) einen Temperaturdetektor (80) zum Messen der aktuellen Akkumulatortemperatur umfasst.

15. Vorrichtung nach einem der Ansprüche 14 bis 14, wobei die Mess- und Auswerteeinrichtung (40) dazu ausgebildet ist, eine Differenz und/oder einen Quotienten eines ermittelten Wertes des Innenwiderstandes des Akkumulators (110) und eines in der Speichereinrichtung (90) gespeicherten zugeordneten Vergleichswertes zu ermitteln und/oder dazu ausgebildet ist, eine Steigung aus den wenigstens zwei bei unterschiedlichen Ladezuständen ermittelten Werten des Innenwiderstandes des Akkumulators (110) zu ermitteln.

16. Unterbrechungsfreie Stromversorgung (30) mit einer Vorrichtung nach einem der Ansprüche 11 bis 15.

## Claims

1. A method of monitoring the operability of a rechargeable battery (110), comprising the steps of:
determining at least two values of internal resistance of the rechargeable battery (110) in respective different partially charged states during charging and/or during discharging of the rechargeable battery (110), wherein for each determined internal resistance value the respective state of charge of the rechargeable battery (110) is determined; and
- determining operability of the rechargeable battery (110) as a function of the determined values of internal resistance and the associated states of charge, wherein at least one characteristic curve is provided which represents the profile of the internal resistance of a fully functional rechargeable battery as a function of the state of charge, and wherein by determining a plurality of internal resistance values of the rechargeable battery, a measurement curve is determined, which is compared to at least one of the provided characteristic curves.

2. The method according to claim 1, further comprising the steps of:
- providing at least one comparison value; and
- comparing at least one determined internal resistance value and/or at least one parameter derived therefrom with the at least one comparison value; wherein the operability of the rechargeable battery (110) is determined as a function of the comparison result.

3. The method according to any one of the preceding claims, wherein internal resistance values of the rechargeable battery (110) are determined at predetermined points in time, in particular cyclically, and/or at predetermined states of charge of the rechargeable battery (110).

4. The method according to any one of the preceding claims, wherein a temperature is associated with each provided comparison value; wherein in particular a plurality of characteristic curves are provided representing the profile of the internal resistance of a fully functional rechargeable battery as a function of the state of charge at different temperatures of the rechargeable battery; and wherein the temperature of the rechargeable battery (110) is determined for each determined internal resistance value of the rechargeable battery (110).

5. The method according to any one of the preceding claims, wherein at least one comparison value represents an internal resistance of a fully functional rechargeable battery at a predetermined state of charge; and wherein the comparing of the at least one determined internal resistance value comprises the calculating of a difference or of a quotient with an associated comparison value.

6. The method according to any one of the preceding claims, wherein at least one comparison value represents a slope of a characteristic curve representing the profile of internal resistance of a fully functional rechargeable battery as a function of the state of charge; and wherein a slope is determined from the at least two internal resistance values determined for different states of charge of the rechargeable battery (110), and is compared with the at least one comparison value.

7. The method according to any one of the preceding claims, wherein the rechargeable battery (110) is identified as insufficiently operational if the comparison result exceeds a predetermined threshold.

8. The method according to any one of the preceding claims, wherein the rechargeable battery (110) is identified as insufficiently operational if on the basis of the determined internal resistance values a drop is identified in the internal resistance occurring during a discharging of the rechargeable battery (110).

9. The method according to any one of the preceding claims, wherein the rechargeable battery (110) comprises a plurality of cells, and wherein a defect of at least one cell of the rechargeable battery (110) is identified by evaluating the profile of a measurement curve defined by a plurality of internal resistance values of the rechargeable battery (110) measured at different states of charge.

10. The method according to any one of the preceding claims, wherein charging current and discharging current balancing is performed to determine the actual state of charge of the rechargeable battery (110).

11. A device for monitoring the operability of a rechargeable battery (110), comprising
a memory device (90) which stores at least one characteristic curve representing the profile of internal resistance of a fully functional rechargeable battery as a function of the state of charge;
a voltage detector (60) for detecting the actual voltage of the rechargeable battery;
a current detector (70) for detecting the actual current of the rechargeable battery; and
a measuring and evaluation device (40) for determining at least two values of internal resistance of the rechargeable battery (110) at different partially charged states during charging and/or during discharging of the rechargeable battery (110) and for determining the state of charge associated with the respective determined internal resistance value of the rechargeable battery (110), said measuring and evaluation device (40) being adapted to
perform charging current and discharging current balancing for determining the actual state of charge of the rechargeable battery (110), and for determining the operability of the rechargeable battery (110) as a function of the determined internal resistance values and of the associated states of charge, wherein the measuring and evaluation device (40) is adapted to identify a defect of at least one cell of the rechargeable battery (110) by evaluating the profile of a measurement curve established by a plurality of internal resistance values of the rechargeable battery (110) measured at different states of charge, and by comparing this measurement curve with one of the stored characteristic curves.

12. The device according to claim 11, wherein the memory device (90) stores at least one comparison value, wherein the measuring and evaluation device (40) is adapted to compare at least one determined internal resistance value and/or at least one parameter derived therefrom with an associated stored comparison value and to determine the operability of the rechargeable battery (110) as a function of the comparison result.

13. The device according to any one of claims 11 or 12, wherein the measuring and evaluation device (40) is adapted to determine internal resistance values of the rechargeable battery (110) at predetermined points in time, in particular cyclically, and/or at predetermined states of charge of the rechargeable battery (110).

14. The device according to any one of claims 11 to 13, wherein the memory device (90) stores a plurality of characteristic curves which represent the profile of internal resistance of a fully functional rechargeable battery as a function of the state of charge at different temperatures of the rechargeable battery; and wherein the device (30) comprises a temperature sensor (80) for measuring the actual temperature of the rechargeable battery.

15. The device according to any one of claims 11 to 14, wherein the measuring and evaluation device (40) is adapted to determine a difference and/or a quotient of a determined internal resistance value of the rechargeable battery (110) and of an associated comparison value stored in the memory device (90), and/or is adapted to determine a slope on the basis of at least two internal resistance values of the rechargeable battery (110) determined at different states of charge.

16. An uninterruptible power supply (30), comprising a device according to any one of claims 11 to 15.

## Revendications

1. Procédé de surveillance du bon fonctionnement d'un accumulateur (110), comprenant les étapes suivantes :
- déterminer au moins deux valeurs de la résistance interne de l'accumulateur (110) dans des états en partie chargés respectivement différents pendant la charge et/ou pendant la décharge de l'accumulateur (110), où l'état de charge respectif de l'accumulateur (110) est déterminé pour chaque valeur déterminée de la résistance interne,
et
- déterminer le bon fonctionnement de l'accumulateur (110) en fonction des valeurs déterminées de la résistance interne et des états de charge associés, où au moins une courbe caractéristique est fournie, laquelle représente la variation de la résistance interne d'un accumulateur fonctionnant parfaitement bien en fonction de l'état de charge, et où la détermination d'une pluralité de valeurs de la résistance interne de l'accumulateur permet de déterminer une courbe de mesure, laquelle est comparée à au moins l'une des courbes caractéristiques fournies.

2. Procédé selon la revendication 1, comprenant en outre les étapes suivantes :
- fournir au moins une valeur de comparaison, et
- comparer au moins une valeur déterminée de la résistance interne et/ou au moins une grandeur dérivée de celle-ci à l'au moins une valeur de comparaison, où
le bon fonctionnement de l'accumulateur (110) est déterminé en fonction du résultat de la comparaison.

3. Procédé selon l'une quelconque des revendications précédentes, dans lequel des valeurs de la résistance interne de l'accumulateur (110) sont déterminées à des moments prédéfinis, en particulier de manière cyclique, et/ou à des états de charge prédéfinis de l'accumulateur (110).

4. Procédé selon l'une quelconque des revendications précédentes, dans lequel une température est associée à chaque valeur de comparaison fournie, dans lequel en particulier une pluralité de courbes caractéristiques sont fournies, lesquelles représentent la variation de la résistance interne d'un accumulateur fonctionnant parfaitement bien en fonction de l'état de charge à des températures de l'accumulateur respectivement différentes, et dans lequel la température de l'accumulateur (110) est déterminée pour chaque valeur déterminée de la résistance interne de l'accumulateur (110).

5. Procédé selon l'une quelconque des revendications précédentes, dans lequel au moins une valeur de comparaison représente une résistance interne d'un accumulateur fonctionnant parfaitement bien pour un état de charge prédéfini, et dans lequel la comparaison de l' au moins une valeur déterminée pour la résistance interne comprend la formation d'une différence ou d'un quotient avec une valeur de comparaison associée.

6. Procédé selon l'une quelconque des revendications précédentes, dans lequel au moins une valeur de comparaison représente une pente d'une courbe caractéristique représentant la variation de la résistance interne d'un accumulateur fonctionnant parfaitement bien en fonction de l'état de charge, et dans lequel une pente est déterminée à partir des au moins deux valeurs déterminées à différents états de charge pour la résistance interne de l'accumulateur (110) et est comparée à l'au moins une valeur de comparaison.

7. Procédé selon l'une quelconque des revendications précédentes, dans lequel l'accumulateur (110) est reconnu comme ne présentant pas un fonctionnement suffisamment bon lorsque le résultat de la comparaison dépasse une valeur seuil prédéfinie.

8. Procédé selon l'une quelconque des revendications précédentes, dans lequel l'accumulateur (110) est reconnu comme ne présentant pas un fonctionnement suffisamment bon lorsqu'une chute de la résistance interne apparaissant pendant une décharge de l'accumulateur (110) est repérée à partir des valeurs déterminées de la résistance interne.

9. Procédé selon l'une quelconque des revendications précédentes, dans lequel l'accumulateur (110) comprend une pluralité d'éléments, et dans lequel l'évaluation de l'allure d'une courbe de mesure formée par une pluralité de valeurs de la résistance interne de l'accumulateur (110) déterminées à différents états de charge permet de repérer un défaut d'au moins un élément de l'accumulateur (110).

10. Procédé selon l'une quelconque des revendications précédentes, dans lequel un équilibrage du courant de charge et de décharge est réalisé, afin de déterminer l'état de charge actuel de l'accumulateur (110).

11. Dispositif de surveillance du bon fonctionnement d'un accumulateur (110), comprenant :
un dispositif de mémoire (90) dans lequel au moins une courbe caractéristique est mise en mémoire, laquelle représente la variation de la résistance interne d'un accumulateur fonctionnant parfaitement bien en fonction de l'état de charge,
un détecteur de tension (60) destiné à détecter la tension actuelle de l'accumulateur,
un détecteur de courant (70) destiné à détecter le courant actuel de l'accumulateur, et
un dispositif de mesure et d'évaluation (40) destiné à déterminer au moins des deuxièmes valeurs de la résistance interne de l'accumulateur (110) dans différents états partiellement chargés pendant la charge et/ou pendant la décharge de l'accumulateur (110) et à déterminer l'état de charge de l'accumulateur (110), lequel état est associé à la valeur respectivement déterminée de la résistance interne, où le dispositif de mesure et d'évaluation (40) est conçu pour réaliser un équilibrage du courant de charge et du courant de décharge pour déterminer l'état de charge actuel de l'accumulateur (110), et, en fonction des valeurs déterminées de la résistance interne et des états de charge associés, pour déterminer le bon fonctionnement de l'accumulateur (110), où le dispositif de mesure et d'évaluation (40) est conçu pour repérer un défaut d'au moins un élément de l'accumulateur (110) par évaluation du tracé d'une courbe de mesure formée par une pluralité de valeurs de la résistance interne de l'accumulateur (110) déterminées à différents états de charge, ainsi que par comparaison de cette courbe de mesure à l'une des courbes caractéristiques mises en mémoire.

12. Dispositif selon la revendication 11, dans lequel au moins une valeur de comparaison est mise en mémoire dans le dispositif de mémoire (90), dans lequel le dispositif de mesure et d'évaluation (40) est conçu pour comparer au moins une valeur déterminée de la résistance interne et/ou au moins une grandeur dérivée de celle-ci à une valeur de comparaison mise en mémoire associée et pour déterminer le bon fonctionnement de l'accumulateur (110) en fonction du résultat de la comparaison.

13. Dispositif selon l'une quelconque des revendications 11 et 12, dans lequel le dispositif de mesure et d'évaluation (40) est conçu pour déterminer des valeurs de la résistance interne de l'accumulateur (110) à des moments prédéfinis, en particulier de manière cyclique, et/ou à des états de charge prédéfinis de l'accumulateur (110).

14. Dispositif selon l'une quelconque des revendications 11 à 13, dans lequel une pluralité de courbes caractéristiques sont mises en mémoire dans le dispositif mémoire (90), lesquelles représentent la variation de la résistance interne d'un accumulateur fonctionnant parfaitement bien en fonction de l'état de charge à des températures respectivement différentes de l'accumulateur et le dispositif (30) comprend un détecteur de température (80) destiné à mesurer la température actuelle de l'accumulateur.

15. Dispositif selon l'une quelconque des revendications 14 à 14, dans lequel le dispositif de mesure et d'évaluation (40) est conçu pour déterminer une différence et/ou un quotient d'une valeur déterminée de la résistance interne de l'accumulateur (110) et d'une valeur de comparaison associée mise en mémoire dans le dispositif mémoire (90) et/ou est conçu pour déterminer une pente à partir des au moins deux valeurs de la résistance interne de l'accumulateur (110) déterminées à différents états de charge.

16. Alimentation en courant électrique sans interruption (30) comprenant un dispositif selon l'une quelconque des revendications 11 à 15.
